# EUROPÄISCHE PATENTANMELDUNG

(11) **EP 0 642 165 A2**
(43) Veröffentlichungstag der Anmeldung: **08.03.1995**
(21) Anmeldenummer: 94111931.5
(22) Anmeldetag: 30.07.1994
(51) Int. Cl.: H01L 25/16, H01L 23/055, H01L 23/495

(54) **Hybridrahmen**

(30) Priorität: 03.08.1993 DE 4325942
(71) Anmelder: DODUCO GMBH + Co Dr. Eugen Dürrwächter, D-75181 Pforzheim (DE)
(72) Erfinder: Bender, Herbert, D-74889 Sinsheim (DE); Ney, Joachim, D-75223 Niefern (DE); Normann, Norbert, Dr., D-75223 NIefern (DE); Waibel, Brigitte, D-75173 Pforzheim (DE)
(74) Vertreter: Twelmeier, Ulrich, Dipl.Phys.

(57) **Zusammenfassung**

Gegenstand ist ein Hybridrahmen aus Kunststoff mit elektrischen Verbindungselementen (2). Die Elemente (2) weisen Kontaktfahnen (3;4) auf, die i.w. rechtwinklig zueinander ausgebildet sind und mit einem zwischen den Kontaktfahnen (3;4) liegenden Knickbereich. Der Knickbereich ist vom Rahmen umgeben. Zwischen den Kontaktfahnen (3;4) und im Knickbereich ist wenigstens ein grader Abschnitt (6a; 6b) vorgesehen. Auf dem, dem Rahmeninnenraum nähergelegenem Abschnitt (6a) ist vorzugsweise eine Versteifung (9) in Form einer Prägung vorgesehen.

## Beschreibung

Die Erfindung geht aus von einem Hybridrahmen mit den im Oberbegriff des Anspruchs 1 angegebenen Merkmalen.

Bei den Hybridrahmen handelt es sich um Gehäuserahmen aus Kunststoff, in welche elektrische Verbindungselemente eingespritzt sind. Der eine Endbereich des Verbindungselements ragt in das Innere des Gehäuserahmens (Bondfahne) hinein. Der andere Endbereich des Verbindungselementes ist nach außen geführt (Kontaktfahne). Der Bereich zwischen den Kontakt- und Bondflächen ist vom Kunststoff umgeben.

Die in den Innenraum des Gehäusrahmens ragenden Bondfahnen werden mit einem im Innenraum des Rahmen montierbaren Hybridschaltkreis od. einem DCB-Substrat verbunden. Die nach außen geführten Kontaktfahnen dienen der elektrischen Verbindung, z.B. als Flachstecker od. als Lötanschlüsse.

Die Verbindung der elektrischen Schaltung mit den in den Innenraum des Hybridrahmens ragenden Bondfahnen erfolgt mittels Ultraschall-Drahtbonden. Hierzu weisen die Bondfahnen bondbare Oberflächen auf.

Insbesondere beim Dickdrahtbohnen wird zum Teil eine erhebliche Schwingungsenergie durch das Bondwerkzeug an der Bondstelle eingebracht. Dies kann zu einer Schwingungsanregung des Verbindungselements führen. Schwingt die Bondfahne des Verbindungselements, so wird die Qualität der Bondverbindung erheblich herabgesetzt. Im Extremfall kann durch die Schwingung eine Bondverbindung gänzlich verhindert werden. Die Empfindlichkeit des Verbindungselements auf eine Schwingungsanregung hängt sowohl von der Form des Verbindungselements als auch von der Art der Einbettung im Hybridrahmen ab. Als besonders kritisch hinsichtlich Schwingungen haben sich Verbindungselemente erwiesen, die aus konstruktiv bedingten Gründen sich nicht flach durch einen Schenkel eines Rahmens erstreckt, sondern aus der Ebene der Bondfläche heraus gewinkelt ist.

Das Problem der Schwingungsanregung ist bereits erkannt worden. Um die Schwingungen zu dämpfen ist vorgeschlagen worden eine möglichst enge Verbindung zwischen dem Verbindungselement und dem Rahmen herzustellen. Dies ist bei gespritzten Kunststoffrahmen möglich, indem entsprechende Spritzparameter, eingehalten werden. Desweiteren ist es bekannt im Bereich der Bondflächen eine Abstützfläche aus Kunststoff, die integraler Bestandteil des Hybridrahmens ist, zu erzeugen. Diese Maßnahmen reichen bei flach ausgebildeten Verbindungselmenten aus.

Die Erfahrung hat jedoch gezeigt, daß bei Verbindungselementen für Hybridrahmen, bei denen Bond- und Kontaktfahne i.w. rechtwinklig zueinander ausgebildet sind, trotz solcher Maßnahmen immer wieder Schwingungsprobleme auftreten. Diese Schwingungsprobleme führen dazu, daß der Ausschuß solcher Hybridrahmen wesentlich höher ist als bei Hybridrahmen mit Verbindungselementen, die sich flach durch den Hybridrahmen erstrecken.

Der vorliegenden Erfindung liegt die Aufgabe zugrunde den bekannten Hybridrahmen mit elektrischen Verbindungselementen so weiterzubilden, daß eine maxial mögliche Schwingungsdämpfung erzielt wird.

Diese Aufgabe wird durch die Merkmale des Anspruchs 1 gelöst. Vorteilhafte Weiterbildungen sind Gegenstand der Unteransprüche.

Überraschenderweise hat es sich gezeigt, daß eine Dämpfung dadurch erzielt werden kann, daß das Verbindungselement wenigstens zwei Knick- oder Biegestellen von 45° oder weniger besitzt. Zwischen den Knicken liegt jeweils ein flacher Abschnitt. Während bei einem Verbindungselement, bei welchem eine einzige 90°-Knickung vorliegt weniger charakteristische Schwingungsformen auftreten, die bei passender Dimensionierung im kritischen Frequenzbereich des Bodens liegen, führt die erfindungsgemäße Ausbildung des Verbindungselementes zu einer Geometrie mit einem breit verteilten, gedämpften Spektrum vieler Einzelschwingungen. Damit werden Schwingungsamplituden im kritischen Frequenzbereich deutlich reduziert. Diese Reduzierung der Schwingungsamplituden hat den Vorteil, daß nunmehr eine sichere Bondverbindung mit Ultraschall erzielt werden kann.

Es hat sich als vorteilhaft erwiesen, wenn mehrere Abschnitte vorgesehen sind, diese so auszubilden, daß der Winkel α zwischen zwei benachbarten Abschnitten stets gleich ist.

Bei dem Verbindungselement handelt es sich vorteilhafterweise um ein Stanzteil.

Es ist an und für sich bekannt, bei Hybridrahmen mit elektrischen Verbindungselementen, die sich flach durch den Rahmen erstrecken, diese durch Prägungen zu versteifen. Gemäß einem weiteren erfinderischen Gedanken wird vorgeschlagen, im Bereich einzelner Biegestellen Versteifungen, vorzugsweise in Form von Prägungen auszubilden. Diese beeinflussen in vorteilhafter Weise die Dämpfung.

Weist das Verbindungselement nur einen graden Abschnitt auf, so ist das Verbindungselement an zwei Stellen (Biegestellen) gebogen. Bei solch einem ausgebildeten Verbindungselement ist es vorteilhaft, die Versteifung an der dem Innenraum des Rahmens näher gelegenen Biegestellen auszubilden. Durch diese Versteifung wird die Schwingung weiter gedämpft.

Weitere Vorteile und Merkmale werden anhand zweier Ausführungsbeispiele beschrieben. Hierbei zeigt
- Figur 1: einen Hybridrahmen in der Draufsicht zum Stand der Technik,
- Figur 2: den Hybridrahmen nach Figur 1 in der Seitenansicht von links,
- Figur 3: ein Verbindungselement nach dem Stand der Technik,
- Figur 4: ein erstes Ausführungsbeispiel eines Verbindungselements,
- Figur 5: ein zweites Ausführungsbeispiel eines Verbindungselements.

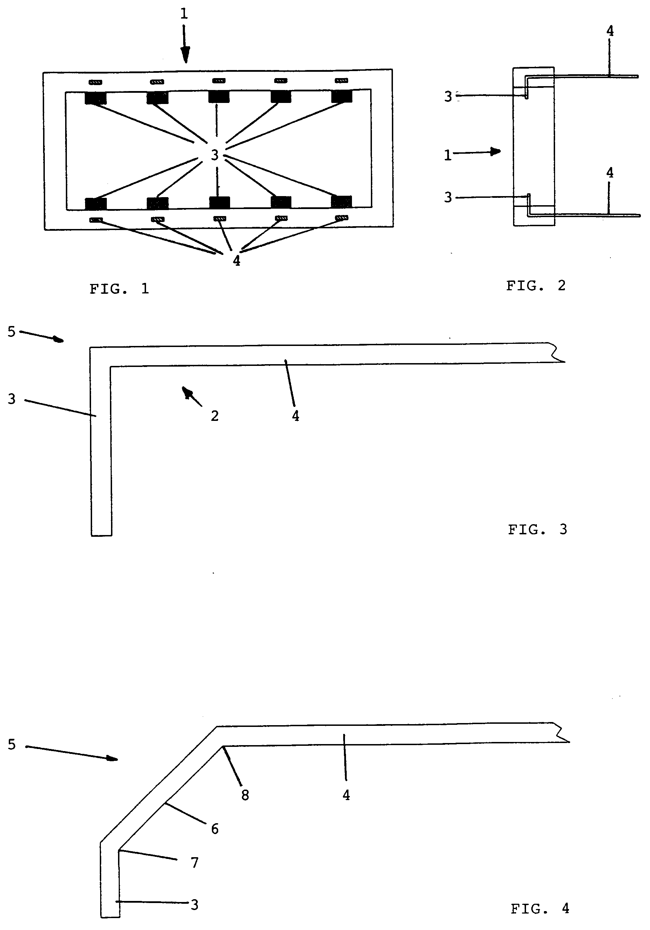

In der Figur 1 ist ein bekannter Hybridrahmen dargestellt. Der Hybridrahmen besteht aus Kunststoff. In den Hybridrahmen 1 sind Verbindungselemente 2 eingespritzt. Die Verbindungselemente weisen Kontakt- (4) und Bondfahnen (3) auf. Die Bondfahnen 3 ragen in das Innere des Rahmens 1 hinein. In der Darstellung nach Figur 1 ist eine Hybridschaltung bzw. ein DCB-Substrat der Übersichtlichkeit halber nicht dargestellt.

Die Kontaktfahnen 4 sind i.w. rechtwinklig zu den Bondfahnen 3 abgewinkelt. Der Knickbereich 5 zwischen der Bond- und Kontaktfahne 3 und 4 ist vom Hybridrahmen 1 umgeben.

In der Figur 4 ist eine erste erfindungsgemäße Ausführungsform eines elektrischen Verbindungselementes dargestellt, wie dieses im Hybridrahmen eingespritzt wird.

Das Verbindungselement 2 weist Bond- und Kontaktfahne 3 und 4 auf. Die Bond- und Kontaktfahne 3 und 4 liegen i.w. rechtwinklig zueinander. Zwischen Bond- und Kontaktfahne 3 und 4 und im Knickbereich 5 ist ein flacher Abschnitt 6 vorgesehen. Das Verbindungselement 2 weist zwischen der Bondfahne 3 und dem Abschnitt 6 eine erste Knickstelle 7 und zwischen dem Abschnitt 6 und der Kontaktfahne 4 eine zweite Knickstelle 8 auf.

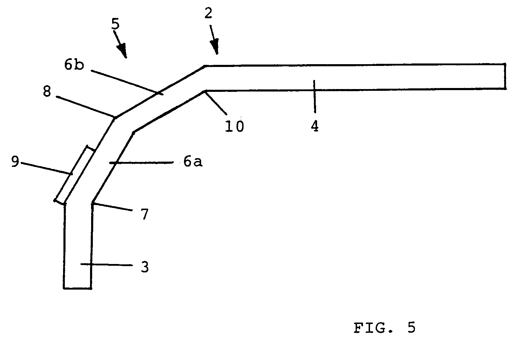

In der Figur 5 ist ein Verbindungselement 2 mit Bond- und Kontaktfahne 3 und 4 dargestellt. Die Fahnen 3, 4 liegen i.w. rechtwinklig zueinander. Zwischen den Fahnen 3 und 4 und im Knickbereich 5 sind zwei flache Abschnitte 6a, 6b vorgesehen. An der in dem Innenraum des Rahmens nähergelegenen Biegestelle 7 ist auf dem Abschnitt 6a eine Versteifung 9 in Form einer Prägung ausgebildet.

In der Darstellung nach Figur 5 ist der Winkel zwischen der Bondfahne 3 und dem flachen Abschnitt 6a, der Winkel zwischen den flachen Abschnitten 6a und 6b sowie zwischen dem flachen Abschnitt 6b und der Kontaktfahne 4 gleich groß.

## Patentansprüche

1. Hybridrahmen (1) mit elektrischen Verbindungselementen (2) mit Bond- und Kontaktfahnen (3;4), die i.w. rechtwinklig zueinander ausgebildet sind und mit einem zwischen den Fahnen (3;4) liegendem Knickbereich (5), welcher vom Rahmen (1) umgeben ist, **dadurch gekennzeichnet,**daß zwischen den Fahnen (3;4) und im Knickbereich wenigstens ein flacher Abschnitt (6; 6a; 6b) vorgesehen ist.

2. Hybridrahmen nach Anspruch 1, **dadurch gekennzeichnet,** daß der Winkel (α) zwischen zwei benachbarten Abschnitten (6a; 6b) und/oder zwischen der Bond- bzw. Kontaktfahne (3 bzw. 4) und dem benachbarten Abschnitt (6; 6a bzw. 6b) gleich ist.

3. Hybridrahmen nach Anspruch 1 oder 2, **dadurch gekennzeichnet**, daß das Verbindungselement ein Stanzteil ist.

4. Hybridrahmen nach einem oder mehreren Ansprüchen 1 bis 3, **dadurch gekennzeichnet,** daß im Bereich einzelner Biegestellen (7; 8), Versteifungen (9) vorzugsweise in Form von Prägungen ausgebildet sind.

5. Hybridrahmen nach Anspruch 4, **dadurch gekennzeichnet,** daß bei einem Verbindungselement mit einem graden Abschnitt eine Versteifung und diese an der dem Innenraum des Rahmens näher gelegenen Biegestelle ausgebildet ist.
